# EUROPÄISCHE PATENTANMELDUNG

(11) **EP 3 442 006 A2**
(43) Veröffentlichungstag der Anmeldung: **13.02.2019**
(21) Anmeldenummer: 18196492.5
(22) Anmeldetag: 25.01.2011
(51) Int. Cl.: H01L 21/18, H01L 21/20, H01L 21/762, H01L 21/70, H01L 23/00

(54) **VERFAHREN ZUM PERMANENTEN BONDEN VON WAFERN**

(62) Teilanmeldung aus: 15197291.6
(71) Anmelder: EV Group E. Thallner GmbH, 4782 St. Florian am Inn (AT)
(72) Erfinder: Plach, Thomas, 4782 St. Florian am Inn (AT); HINGERL, Kurt, 4493 Wolfern (AT); WIMPLINGER, Markus, 4910 Ried im Innkreis (AT)
(74) Vertreter: Schweiger, Johannes

(57) **Zusammenfassung**

Die vorliegende Erfindung betrifft ein Verfahren Verfahren zum Bonden einer ersten Kontaktfläche (3) eines ersten Substrats (1) mit einer zweiten Kontaktfläche (4) eines zweiten Substrats (2) mit folgenden Schritten, insbesondere folgendem Ablauf:
- Ausbildung eines Reservoirs (5) in einer Oberflächenschicht (6) an der ersten Kontaktfläche (3) durch Beaufschlagung der ersten Kontaktfläche (3) mit N2-Gas und/oder O₂-Gas und/oder Ar-Gas und/oder Formiergas, insbesondere bestehend aus 95% Ar und 5% H₂,
- zumindest teilweises Auffüllen des Reservoirs (5) mit einem ersten Edukt oder einer ersten Gruppe von Edukten,
- Kontaktieren der ersten Kontaktfläche (3) mit der zweiten Kontaktfläche (4) zur Ausbildung einer Pre-Bond-Verbindung,
- Ausbildung eines permanenten Bonds zwischen der ersten und zweiten Kontaktfläche (3, 4), zumindest teilweise verstärkt durch Reaktion des ersten Edukts mit einem in einer Reaktionsschicht (7) des zweiten Substrats enthaltenen zweiten Edukt.

## Beschreibung

Die vorliegende Erfindung betrifft ein Verfahren zum Bonden einer ersten Kontaktfläche eines ersten Substrats mit einer zweiten Kontaktfläche eines zweiten Substrats gemäß Patentanspruch 1.

Ziel beim permanenten oder irreversiblen Bonden von Substraten ist es, zwischen den beiden Kontaktflächen der Substrate eine möglichst starke und insbesondere unwiderrufliche Verbindung, also eine hohe Bondkraft, zu erzeugen. Hierfür existieren im Stand der Technik verschiedene Ansätze und Herstel ungsverfahren.

Die bekannten Herstellungsverfahren und bisher verfolgten Ansätze führen häufig zu nicht oder schlecht reproduzierbaren und insbesondere kaum auf veränderte Bedingungen übertragbaren Ergebnissen. Insbesondere benutzen derzeit eingesetzte Herstellungsverfahren häufig hohe Temperaturen, insbesondere >400°C, um wiederholbare Ergebnisse zu gewährleisten.

Technische Probleme wie hoher Energieverbrauch und eine mögliche Zerstörung von auf den Substraten vorhandenen Strukturen resultieren aus den bisher für eine hohe Bondkraft erforderlichen hohen Temperaturen von teilweise weit über 300° C.

Weitere Anforderungen bestehen in:
- der Front-end-of-line-Kompatibilität.
   Darunter versteht man die Kompatibilität des Prozesses während der Herstellung der elektrisch aktiven Bauteile. Der Bondingprozess muss also so ausgelegt werden, dass aktive Bauelemente wie Transistoren, die bereits auf den Strukturwafern vorhanden sind, während der Prozessierung weder beeinträchtigt noch geschädigt werden. Zu den Kompatibilitätskriterien zählen vor allem die Reinheit an gewissen chemischen Elementen (vor allem bei CMOS Strukturen), mechanische Belastbarkeit, vor allem durch Thermospannungen.
- niedrige Kontamination.
- keine Krafteinbringung.
Die Reduktion der Bondkraft führt zu einer schonenderen Behandlung der Strukturwafer, und damit zu einer Reduktion der Ausfallswahrscheinlichkeit durch direkte mechanische Belastung.

Aufgabe der vorliegenden Erfindung ist es daher, ein Verfahren zur schonenden Herstellung eines permanenten Bonds mit einer möglichst hohen Bondkraft anzugeben.

Diese Aufgabe wird mit den Merkmalen des Patentanspruchs 1 gelöst. Vorteilhafte Weiterbildungen der Erfindung sind in den Unteransprüchen angegeben. In den Rahmen der Erfindung fallen auch sämtliche Kombinationen aus zumindest zwei von in der Beschreibung, den Ansprüchen und/oder den Figuren angegebenen Merkmalen. Bei angegebenen Wertebereichen sollen auch innerhalb der genannten Grenzen liegende Werte als Grenzwerte offenbart gelten und in beliebiger Kombination beanspruchbar sein.

Die Grundidee der vorliegenden Erfindung ist es, zumindest an einem der Substrate ein Reservoir zur Aufnahme eines ersten Edukts zu schaffen, das nach der Kontaktierung beziehungsweise Herstellung eines vorläufigen Bonds zwischen den Substraten mit einem zweiten Edukt, das in dem anderen Substrat vorliegt, zu reagieren und dadurch einen irreversiblen beziehungsweise permanenten Bond zwischen den Substraten auszubilden. Vor oder nach der Ausbildung des Reservoirs in einer Oberflächenschicht an der ersten Kontaktfläche findet meist eine Reinigung des oder der Substrate, insbesondere durch einen Spülschritt, statt. Diese Reinigung soll zumeist sicherstellen, dass sich keine Partikel auf den Oberflächen befinden, die ungebondete Stellen zur Folge haben würden. Durch das Reservoir und das im Reservoir enthaltene Edukt wird eine technische Möglichkeit geschaffen, unmittelbar an den Kontaktflächen nach der Herstellung des vorläufigen beziehungsweise reversiblen Bonds gezielt eine den permanenten Bond verstärkende und die Bondgeschwindigkeit erhöhende Reaktion zu induzieren, insbesondere durch Verformung mindestens einer der Kontaktflächen durch die Reaktion, vorzugsweise der dem Reservoir gegenüberliegenden Kontaktfläche.

Für den Pre-Bonding-Schritt zur Erzeugung eines vorläufigen oder reversiblen Bonds zwischen den Substraten sind verschiedene Möglichkeiten vorgesehen mit dem Ziel, eine schwache Interaktion zwischen den Kontaktflächen der Substrate zu erzeugen. Die Prebondstärken liegen dabei unter den Permanentbondstärken, zumindest um den Faktor 2 bis 3, insbesondere um den Faktor 5, vorzugsweise um den Faktor 15, noch bevorzugter um den Faktor 25.Als Richtgrößen werden die Pre-Bondstärken von reinem, nicht aktiviertem, hydrophilisierten Silizium mit ca. 100mJ/m² und von reinem, plasmaaktivierten hydrophiliserten Silizium mit ca. 200-300mJ/m² erwähnt. Die Prebonds zwischen den mit Molekülen benetzten Substraten kommen hauptsächlich durch die van-der-Waals Wechselwirkungen zwischen den Molekülen der unterschiedlichen Waferseiten zustande. Dementsprechend sind vor allem Moleküle mit permanenten Dipolmomenten dafür geeignet, Prebonds zwischen Wafern zu ermöglichen. Als Verbindungsmittel werden folgende chemische Verbindungen beispielhaft, aber nicht einschränkend, genannt
- Wasser,
- Tiole,
- AP3000,
- Silane und/oder
- Silanole

Als erfindungsgemäße Substrate sind solche Substrate geeignet, deren Material in der Lage ist, als Edukt mit einem weiteren zugeführten Edukt zu einem Produkt mit einem höheren molaren Volumen zu reagieren, wodurch die Bildung einer Aufwuchsschicht auf dem Substrat bewirkt wird. Besonders vorteilhaft sind die nachfolgenden Kombinationen, wobei jeweils links vom Pfeil das Edukt und rechts vom Pfeil das Produkt / die Produkte genannt ist, ohne das mit dem Edukt reagierende zugeführte Edukt oder Nebenprodukte im Einzelnen zu benennen:
- Si→SiO₂, Si₃N₄, SiNₓO_{y}
- Ge→ GeO₂, Ge₃N₄
- α-Sn→ SnO₂
- B→ B₂O₃, BN
- Se→ SeO₂
- Te→ TeO₂, TeO₃
- Mg→ MgO, Mg₃N₂
- Al→ Al₂O₃, AlN
- Ti→ TiO₂, TiN
- V→ V₂O₅
- Mn→ MnO, MnO₂, Mn₂O₃, Mn₂O₇, Mn₃O₄
- Fe → FeO, Fe₂O₃, Fe₃O₄
- Co→ CoO, Co₃O₄,
- Ni→ NiO, Ni₂O₃
- Cu→ CuO Cu₂O, Cu₃N
- Zn→ ZnO
- Cr→ CrN, Cr₂₃C₆, Cr₃C, Cr₇C₃, Cr₃C₂
- Mo→ Mo₃C₂
- Ti→ TiC
- Nb→ Nb₄C₃
- Ta→ Ta₄C₃
- Zr→ ZrC
- Hf→ HfC
- V→ V₄C₃, VC
- W→ W₂C, WC
- Fe→ Fe₃C, Fe₇C₃, Fe₂C.

Als Substrate sind außerdem folgende Mischformen von Halbleitern denkbar:
- III-V: GaP, GaAs, InP, InSb, InAs, GaSb, GaN, AlN, InN, AlₓGa₁₋ₓAs, InₓGa₁₋ₓN
- IV-IV: SiC, SiGe,
- III-VI: InAlP.
- nichtlineare Optik: LiNbO₃, LiTaO₃, KDP (KH₂PO₄)
- Solarzellen: CdS, CdSe, CdTe, CuInSe2, CuInGaSe₂, CuInS2, CuInGaS₂
- Leitende Oxide: In₂₋ₓSnxO_{3-y}

Erfindungsgemäß wird an mindestens einem der Wafer, und zwar unmittelbar an die jeweilige Kontaktfläche ein Reservoir vorgesehen, in welchem eine gewisse Menge mindestens eines der zugeführten Edukte für die Volumenexpansionsreaktion speicherbar ist. Edukte können also beispielsweise O₂, O₃, H₂O, N2, NH3, H₂O₂ etc. sein. Durch die Expansion, insbesondere bedingt durch Oxidwachstum, werden auf Grund der Bestrebung der Reaktionspartner, die Systemenergie abzusenken, etwaige Lücken, Poren, Hohlräume zwischen den Kontaktflächen minimiert und die Bondkraft entsprechend durch Annäherung der Abstände zwischen den Substraten in diesen Bereichen erhöht. Im bestmöglichen Fall werden die vorhandenen Lücken, Poren und Hohlräume komplett geschlossen, sodass die gesamte Bondingfläche zunimmt und damit die Bondkraft erfindungsgemäß entsprechend steigt.

Die Kontaktflächen zeigen üblicherweise eine Rauhigkeit mit einer quadratischen Rauheit (R_{q}) von 0,2 nm auf. Dies entspricht Scheitel-ScheitelWerten der Oberflächen im Bereich von 1 nm. Diese empirischen Werte wurden mit der Atomic Force Microscopy (AFM) ermittelt.

Die erfindungsgemäße Reaktion ist geeignet, bei einer üblichen Waferfläche eines kreisförmigen Wafers mit einem Durchmesser von 200 bis 300 mm mit 1 Monolage (ML) Wasser die Aufwuchsschicht um 0,1 bis 0,3 nm wachsen zu lassen.

Erfindungsgemäß ist daher insbesondere vorgesehen, mindestens 2 ML, vorzugsweise mindestens 5 ML, noch bevorzugter mindestens 10 ML Fluid, insbesondere Wasser, im Reservoir zu speichern.

Besonders bevorzugt ist die Ausbildung des Reservoirs durch Plasmabeaufschlagung, da durch die Plasmabeaufschlagung außerdem eine Glättung der Kontaktfläche sowie eine Hydrophilisierung als Synergieeffekte bewirkt werden. Die Glättung der Oberfläche durch Plasmaaktivierung erfolgt vorwiegend durch einen viskosen Fluss des Materials der Oberflächenschicht. Die Erhöhung der Hydrophilizität erfolgt insbesondere durch die Vermehrung der Siliziumhydroxyl Verbindungen, vorzugsweise durch Cracken von an der Oberfläche vorhandenen Si-O Verbindungen wie Si-O-Si, insbesondere gemäß nachfolgender Reaktion:

Si-O-Si + H₂O ←→ 2SiOH

Ein weiterer Nebeneffekt, insbesondere als Folge der vorgenannten Effekte, besteht darin, dass die Pre-Bond-Stärke, insbesondere um einen Faktor 2 bis 3, verbessert wird.

Die Ausbildung des Reservoirs in der Oberflächenschicht an der ersten Kontaktfläche des ersten Substrats erfolgt beispielsweise durch Plasmaaktivierung des mit einem thermischen Oxid beschichteten ersten Substrats. Die Plasmaaktivierung wird in einer Vakuumkammer durchgeführt, um die für das Plasma erforderlichen Bedingungen einstellen zu können. Erfindungsgemäß wird für die Plasmaentladung N₂-Gas, O₂-Gas oder Argongas mit Ionenenergien im Bereich von 0 bis 2000 eV verwendet, wodurch ein Reservoir mit einer Tiefe von bis zu 20 nm, vorzugsweise bis zu 15 nm, mit größerem Vorzug bis zu 10nm, mit größtem Vorzug bis zu 5nm, der behandelten Oberfläche, in diesem Fall der ersten Kontaktfläche, hergestellt wird. Erfindungsgemäß können jede Partikelart, Atome und/oder Moleküle, verwendet werden, die geeignet sind, das Reservoir zu erzeugen. Mit Vorzug werden jene Atome und/oder Moleküle verwendet, welche das Reservoir mit den benötigten Eigenschaften erzeugt. Die relevanten Eigenschaften sind vor allem die Porengröße, Porenverteilung und Porendichte. Alternativ können erfindungsgemäß Gasmischungen, wie beispielsweise Luft oder Formiergas bestehend aus 95% Ar und 5% H₂ verwendet werden. Abhängig von dem verwendeten Gas sind in dem Reservoir während der Plasmabehandlung unter anderem folgende Ionen anwesend: N+, N₂+, O+, O₂+, Ar+. Im nicht belegten Freiraum ist das erste Edukt aufnehmbar.

Die Ausbildung des Reservoirs erfolgt auf Grund folgender Überlegungen: Die Porengröße ist kleiner als 10nm, mit Vorzug kleiner als 5nm, mit größerem Vorzug kleiner als 1nm, mit noch größerem Vorzug kleiner als 0.5nm, mit größtem Vorzug kleiner als 0.2nm.

Die Porendichte ist mit Vorzug direkt proportional zur Dichte der Partikel, welche die Poren durch Einschlagwirkung erzeugen, mit größtem Vorzug sogar durch den Partialdruck der Einschlagspezies variierbar, sowie abhängig von der Behandlungszeit und den Parametern, insbesondere des verwendeten Plasmasystems.

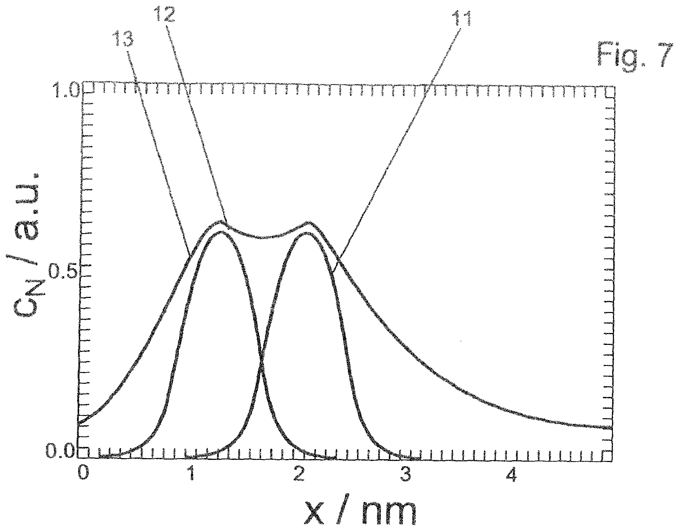

Die Porenverteilung besitzt mit Vorzug mindestens einen Bereich größter Porenkonzentration unter der Oberfläche, durch Variation der Parameter mehrerer solcher Bereiche, welche sich zu einem, vorzugsweise plateauförmigen Bereich, überlagern (siehe Fig. 7). Die Porenverteilung nimmt mit zunehmender Dicke gegen null ab. Der oberflächennahe Bereich besitzt während des Beschusses eine Porendichte, welche mit der Porendichte nahe der Oberfläche beinahe ident ist. Nach dem Ende der Plasmabehandlung kann die Porendichte an der Oberfläche auf Grund von Spannungsrelaxationsmechanismen verringert werden. Die Porenverteilung in Dickenrichtung besitzt bezüglich der Oberfläche eine steile Flanke und bezüglich des Bulks eine eher flachere, aber stetig abnehmende Flanke (siehe Fig. 7).

Für die Porengröße, die Porenverteilung und Porendichte gelten für alle nicht mit Plasma hergestellten Verfahren ähnliche Überlegungen.

Das Reservoir kann durch gezielte Verwendung und Kombination von Prozessparametern designed werden. Fig. 7 zeigt eine Darstellung der Konzentration eingeschossener Stickstoffatome durch Plasma als Funktion der Eindringtiefe in eine Siliziumoxidschicht. Durch Variation der physikalischen Parameter konnten zwei Profile erzeugt werden. Das erste Profil 11 wurde durch stärker beschleunigte Atome tiefer im Siliziumoxid erzeugt, wohingegen das Profil 12, nach Abänderung der Prozessparameter in einer geringeren Dichte erzeugt wurde. Die Überlagerung beider Profile ergibt eine Summenkurve 13, welche charakteristisch für das Reservoir steht. Der Zusammenhang zwischen der Konzentration der eingeschossenen Atom und/oder Molekülspezies ist evident. Höhere Konzentrationen bezeichnen Gebiete mit höherer Defektstruktur, also mehr Raum um das anschließende Edukt aufzunehmen. Eine kontinuierliche, insbesondere gezielt gesteuerte kontinuierliche Änderung der Prozessparameter während der Plasmaaktivierung ermöglicht es, ein Reservoir mit einer möglichst gleichmäßigen Verteilung der eingebrachten Ionen über die Tiefe zu erreichen.

Als Reservoir ist alternativ zu einem durch Plasma erzeugten Reservoir die Verwendung einer TEOS (Tetraethylorthosilikat)-Oxidschicht auf mindestens einem der Substrate, zumindest dem ersten Substrat, denkbar. Dieses Oxid ist insbesondere weniger dicht als thermisches Oxid, weshalb erfindungsgemäß eine Verdichtung vorteilhaft ist. Die Verdichtung erfolgt durch Wärmebehandlung mit dem Ziel einer Einstellung einer definierten Porosität des Reservoirs.

Besonders vorteilhaft kann gemäß einer Ausführungsform der Erfindung die Auffüllung des Reservoirs gleichzeitig mit der Ausbildung des Reservoirs erfolgen, indem das Reservoir als Beschichtung auf dem ersten Substrat aufgebracht wird, wobei die Beschichtung das erste Edukt bereits umfasst.

Das Reservoir ist als poröse Schicht mit einer Porosität im Nanometerbereich oder als Kanäle aufweisende Schicht mit einer Kanaldicke kleiner 10nm, mit größerem Vorzug kleiner als 5 nm, mit noch größerem Vorzug kleiner als 2nm, mit größtem Vorzug kleiner als 1nm, mit allergrößtem Vorzug kleiner als 0.5nm denkbar.

Für den Schritt des Auffüllens des Reservoirs mit dem ersten Edukt oder einer ersten Gruppe von Edukten sind erfindungsgemäß folgende Ausführungsformen, auch in Kombination, denkbar:
- Aussetzen des Reservoirs gegenüber der Umgebungsatmosphäre,
- Spülung mit, insbesondere deionisiertem, Wasser,
- Spülen mit einem das Edukt enthaltenden oder aus diesem bestehenden Fluid, insbesondere H₂O, H₂O₂, NH4OH
- Aussetzen des Reservoirs gegenüber einer beliebigen Gasatmosphäre, insbesondere atomares Gas, molekulares Gas, Gasmischungen,
- Aussetzen des Reservoirs gegenüber einer Wasserdampf oder Wasserstoffperoxiddampf enthaltenden Atmosphäre und
- Ablagerung eines bereits mit dem Edukt befüllten Reservoirs als Oberflächenschicht auf dem ersten Substrat.

Als Edukte kommen die folgenden Verbindungen in Frage: O₂, O₃, N₂, NH₃, H₂O, H₂O₂ und/oder NH₄OH.

Die Verwendung des oben angeführten Wasserstoffperoxiddampfes wird neben der Verwendung von Wasser als bevorzugte Variante angesehen. Wassertstoffperoxid hat des Weiteren den Vorteil, ein größeres Sauerstoff zu Wasserstoffverhältnis zu besitzen. Des Weiteren dissoziiert Wasserstoffperoxid über bestimmten Temperaturen und/oder der Verwendung von Hochfrequenzfeldern im MHz Bereich zu Wasserstoff und Sauerstoff.

Gemäß einer vorteilhaften Ausführungsform der Erfindung ist vorgesehen, dass die Ausbildung der Aufwuchsschicht und Verstärkung des irreversiblen Bonds durch Diffusion des ersten Edukts in die Reaktionsschicht erfolgt.

Gemäß einer weiteren, vorteilhaften Ausführungsform der Erfindung ist vorgesehen, dass die Ausbildung des irreversiblen Bonds bei einer Temperatur von typischerweise weniger als 300°C, mit Vorteil von weniger als 200°C, mit größerem Vorzug weniger als 150°C, mit noch größerem Vorzug weniger als 100°C, mit größtem Vorzug bei Raumtemperatur insbesondere während maximal 12 Tage, bevorzugter maximal 1 Tag, noch bevorzugter maximal 1 Stunde, am bevorzugtesten maximal 15 min., erfolgt.

Dabei ist es besonders vorteilhaft, wenn der irreversible Bond eine Bondstärke von größer 1,5 J/m², insbesondere größer 2 J/m², vorzugsweise größer 2,5 J/m² aufweist.

Die Bondstärke kann in besonders vorteilhafter Weise dadurch erhöht werden, dass bei der Reaktion ein Produkt mit einem größeren molaren Volumen als das molare Volumen des zweiten Edukts in der Reaktionsschicht gebildet wird. Hierdurch wird ein Anwachsen am zweiten Substrat bewirkt, wodurch Lücken zwischen den Kontaktflächen durch die erfindungsgemäße chemische Reaktion geschlossen werden können. Als Folge hieraus wird der Abstand zwischen den Kontaktflächen, also der mittlere Abstand, reduziert und Toträume minimiert.

Soweit die Ausbildung des Reservoirs durch Plasmaaktivierung, insbesondere mit einer Aktivierungsfrequenz zwischen 10 und 600 kHz und/oder einer Leistungsdichte zwischen 0,075 und 0,2 Watt/cm² und/oder unter Druckbeaufschlagung mit einem Druck zwischen 0,1 und 0,6 mbar, erfolgt, werden zusätzliche Effekte wie die Glättung der Kontaktfläche als auch eine deutlich erhöhte Hydrophilität der Kontaktfläche bewirkt.

Alternativ dazu kann die Ausbildung des Reservoirs erfindungsgemäß durch Verwendung einer, insbesondere kontrolliert auf eine bestimmte Porosität verdichteten, Tetraethoxysilan-Oxidschicht als Oberflächenschicht erfolgen.

Gemäß einer weiteren vorteilhaften Ausführungsform der Erfindung ist vorgesehen, dass die Oberflächenschicht überwiegend, insbesondere im wesentlichen vollständig, aus einem, insbesondere amorphen, insbesondere einem durch thermische Oxidation erzeugten Siliziumdioxid, und die Reaktionsschicht aus einem oxidierbaren Material, insbesondere überwiegend, vorzugsweise im wesentlichen vollständig, aus Si, Ge, InP, GaP oder GaN, bestehen. Durch Oxidation wird eine besonders stabile und die vorhandenen Lücken besonders effektiv schließende Reaktion ermöglicht.

Dabei ist es erfindungsgemäß besonders vorteilhaft, wenn zwischen der zweiten Kontaktfläche und der Reaktionsschicht eine Aufwuchsschicht, insbesondere überwiegend aus nativem Siliziumdioxid, vorgesehen ist. Die Aufwuchsschicht unterliegt einem durch die erfindungsgemäße Reaktion bewirkten Wachstum. Das Wachstum erfolgt ausgehend vom Übergang Si-SiO2 (7) durch Neubildung von amorphem SiO2 und dadurch hervorgerufener Verformung, insbesondere Ausbeulung, der Aufwuchsschicht, nisbesondere an der Grenzfläche zur Reaktionsschicht, und zwar insbesondere in Bereichen von Lücken zwischen der ersten und der zweiten Kontaktfläche. Hierdurch wird eine Reduzierung des Abstands beziehungsweise Verringerung des Totraums zwischen den beiden Kontaktflächen bewirkt, wodurch die Bondstärke zwischen den beiden Substraten erhöht wird. Besonders vorteilhaft ist dabei eine Temperatur zwischen 200 und 400°C, bevorzugt in etwa 200°C und 150° C, bevorzugterweise eine Temperatur zwischen 150°C und 100°C, am bevorzugtesten eine Temperatur zwischen 100°C und Raumtemperatur.

Hierbei ist es besonders vorteilhaft, wenn die Aufwuchsschicht vor der Ausbildung des irreversiblen Bonds eine mittlere Dicke A zwischen **0,1** nm und **5** nm aufweist. Je dünner die Aufwuchsschicht, desto schneller und einfacher erfolgt die Reaktion zwischen dem ersten und dem zweiten Edukt durch die Aufwuchsschicht hindurch, insbesondere durch Diffusion des ersten Edukts durch die Aufwuchsschicht hindurch zur Reaktionsschicht.

In vorteilhafter Weise ist gemäß einer Ausführungsform der Erfindung vorgesehen, dass die Ausbildung des Reservoirs im Vakuum durchgeführt wird. Somit können Verunreinigungen des Reservoirs mit nicht erwünschten Materialien oder Verbindungen vermieden werden.

In einer weiteren Ausführungsform der Erfindung ist mit Vorteil vorgesehen, dass das Auffüllen des Reservoirs durch einen oder mehrere der nachfolgend aufgeführten Schritte erfolgt:
- Aussetzen der ersten Kontaktfläche gegenüber der Atmosphäre, zur Auffüllung des Reservoirs mit Luftfeuchtigkeit und / oder in der Luft enthaltenem Sauerstoff.
- Beaufschlagung der ersten Kontaktfläche mit einem, insbesondere überwiegend, vorzugsweise nahezu vollständig, aus, insbesondere deionisiertem, H₂O und/oder H₂O₂ bestehenden, Fluid,
- Beaufschlagung der ersten Kontaktfläche mit N₂-Gas und/oder O₂-Gas und/oder Ar-Gas und/oder Formiergas, insbesondere bestehend aus 95% Ar und 5% H₂, insbesondere mit einer Ionenenergie im Bereich von 0 bis 2000 eV.
- Bedampfung zur Auffüllung des Reservoirs mit einem beliebigen bereits genannten Edukt.

Besonders effektiv für den Verfahrensablauf ist es, wenn das Reservoir mit Vorzug in einer Dicke R zwischen 0,1 nm und 25 nm, mit größerem Vorzug zwischen 0,1 nm und 15 nm, mit noch größerem Vrozug zwischen 0,1 nm und 10 nm, mit größtem Vorzug zwischen 0,1 nm und 5 nm ausgebildet wird. Weiterhin ist es gemäß einer Ausführungsform der Erfindung vorteilhaft, wenn der mittlere Abstand B zwischen dem Reservoir und der Reaktionsschicht unmittelbar vor der Ausbildung des irreversiblen Bonds zwischen 0,1 nm und 15 nm, insbesondere zwischen 0,5 nm und 5 nm, vorzugsweise zwischen 0,5 nm und 3 nm beträgt.

Eine Vorrichtung zur Ausführung des Verfahrens ist erfindungsgemäß mit einer Kammer zur Ausbildung des Reservoirs und einer, insbesondere separat dazu vorgesehenen Kammer zur Füllung des Reservoirs und einer, insbesondere separat vorgesehenen Kammer zur Ausbildung des Pre-Bonds ausgebildet, die direkt über ein Vakuumsystem miteinander verbunden sind.

In einer weiteren Ausführungsform kann das Auffüllen des Reservoirs auch direkt über die Atmosphäre erfolgen, also entweder in einer Kammer, die zur Atmosphäre hin geöffnet werden kann oder einfach auf einem Aufbau, welcher keine Ummantelung besitzt aber den Wafer semi- und/oder vollautomatisch handhaben kann.

Alternativ gilt die vorliegende Beschreibung für ein Verfahren zum Bonden einer ersten Kontaktfläche eines ersten Substrats mit einer zweiten Kontaktfläche eines zweiten Substrats mit folgenden Schritten, insbesondere folgendem Ablauf:
- Ausbildung eines Reservoirs in einer Oberflächenschicht an der ersten Kontaktfläche,
- zumindest teilweises Auffüllen des Reservoirs mit einem ersten Edukt oder einer ersten Gruppe von Edukten,
- Kontaktieren der ersten Kontaktfläche mit der zweiten Kontaktfläche zur Ausbildung einer Pre-Bond-Verbindung,
- Ausbildung eines permanenten Bonds zwischen der ersten und zweiten Kontaktfläche, zumindest teilweise verstärkt durch Reaktion des ersten Edukts mit einem in einer Reaktionsschicht des zweiten Substrats enthaltenen zweiten Edukt.

Weitere Vorteile, Merkmale und Einzelheiten der Erfindung ergeben sich aus der nachfolgenden Beschreibung bevorzugter Ausführungsbeispiele sowie anhand der Zeichnungen. Diese zeigen in:
- Figur 1: einen ersten Schritt des erfindungsgemäßen Verfahrens unmittelbar nach der Kontaktierung des ersten Substrats mit dem zweiten Substrat,
- Figur 2a und 2b: weitere Schritte des erfindungsgemäßen Verfahrens zur Ausbildung einer höheren Bondstärke,
- Figur 3: einen sich an die Schritte gemäß Figur 1, Figur 2a und Figur 2b anschließender weiterer Schritt des erfindungsgemäßen Verfahrens mit in Kontakt stehenden Kontaktflächen der Substrate,
- Figur 4: einen erfindungsgemäßen Schritt zur Ausbildung eines irreversiblen/permanenten Bonds zwischen den Substraten,
- Figur 5: eine vergrößerte Darstellung der an den beiden Kontaktflächen während der Schritte gemäß Figur 3 und Figur 4 ablaufenden chemischen/physikalischen Vorgängen,
- Figur 6: eine weiter vergrößerte Darstellung der an der Grenzfläche zwischen den beiden Kontaktflächen ablaufenden chemischen/physikalischen Vorgänge während der Schritte gemäß Figur 3 und Figur 4 und
- Figur 7: ein Diagramm zur erfindungsgemäßen Erzeugung des Reservoirs.

In den Figuren sind gleiche oder gleichwirkende Merkmale mit den gleichen Bezugszeichen gekennzeichnet.

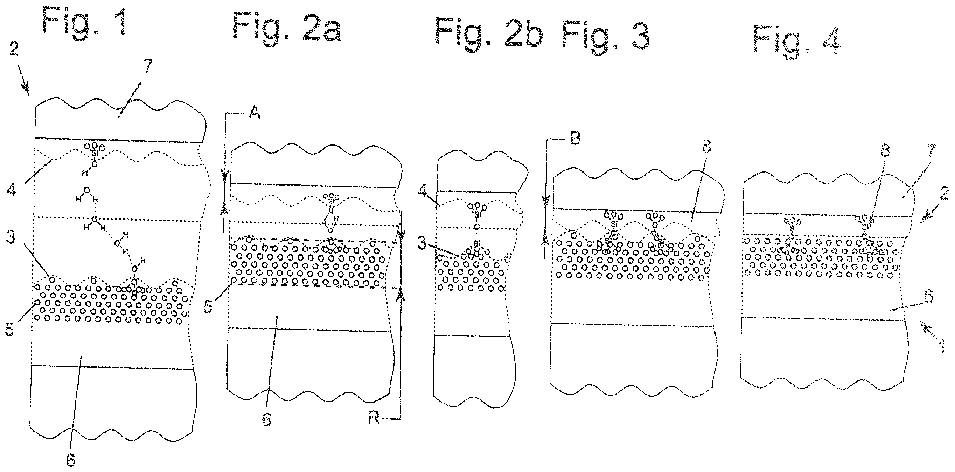

In der in Figur 1 dargestellten Situation, die nur einen Ausschnitt der beim oder unmittelbar nach dem Pre-Bond-Schritt zwischen einer ersten Kontaktfläche 3 eines ersten Substrats 1 und einer zweiten Kontaktfläche 4 eines zweiten Substrats 2 ablaufenden chemischen Reaktionen dargestellt. Die Oberflächen sind mit polaren OH-Gruppen terminiert und entsprechend hydrophil. Das erste Substrat 1 und das zweite Substrat 2 werden durch die Anziehungskraft der Wasserstoffbrücken zwischen den an der Oberfläche vorhandenen OH-Gruppen und den H₂O-Molekülen sowie zwischen den H₂O-Molekülen allein gehalten. Die Hydrophilizität zumindest der ersten Kontaktfläche 3 ist in einem vorangegangenen Schritt durch eine Plasmabehandlung der ersten Kontaktfläche 3 erhöht.

Durch die Plasmabehandlung ist erfindungsgemäß ein Reservoir 5 in einer aus thermischem Siliziumdioxid bestehenden Oberflächenschicht 6 ausgebildet worden. Durch die Plasmabehandlung mit O₂-Ionen mit Ionenenergien im Bereich zwischen 0 und 2000 eV wird eine mittlere Dicke R des Reservoirs 5 von etwa 15 nm erreicht, wobei die Ionen Kanäle beziehungsweise Poren in der Oberflächenschicht 6 ausbilden.

Ebenfalls vor dem in Figur 1 gezeigten Schritt und nach der Plasmabehandlung wird das Reservoir 5 mit H₂O als erstes Edukt aufgefüllt. Im Reservoir können sich auch reduzierte Spezies der im Plasmaprozess vorhandenen Ionen befinden, insbesondere O₂, N₂, H₂, Ar.

Die Kontaktflächen 3, 4 weisen daher noch einen relativ weiten Abstand auf, insbesondere bedingt durch das zwischen den Kontaktflächen 3, 4 vorhandene Wasser. Entsprechend ist die vorhandene Bondstärke relativ gering und liegt etwa zwischen 100 mJ/cm² und 300 mJ/cm², insbesondere über 200 mJ/cm². Hierbei spielt die vorherige Plasmaaktivierung, insbesondere wegen der erhöhten Hydrophilizität der plasmaaktivierten ersten Kontaktfläche 3 sowie einem durch die Plasmaaktivierung verursachten Glättungseffekt, eine entscheidende Rolle.

Der in Fig. 1 dargestellte, als Prebond bezeichnete, Vorgang kann vorzugsweise bei Umgebungstemperatur oder maximal 50° Celsius ablaufen. Die Fig. 2a und 2b zeigen einen hydrophilen Bond, wobei die Si-O-Si Brücke unter Abspaltung von Wasser durch -OH terminierte Oberflächen zustande kommt. Die Vorgänge in Fig. 2a und 2b dauern bei Raumtemperatur ca. 300h. Bei 50°C ca. 60h. Der Zustand in Fig. 2b tritt ohne Herstellung des Reservoirs bei den genannten Temperaturen nicht auf.

Zwischen den Kontaktflächen 3, 4 werden H₂O-Moleküle gebildet, die zumindest teilweise für eine weitere Auffüllung im Reservoir 5 sorgen, soweit noch Freiraum vorhanden ist. Die übrigen H₂O-Moleküle werden entfernt. In der Stufe gemäß Figur 1 sind etwa 3 bis 5 Einzelschichten von OH-Gruppen beziehungsweise H₂O vorhanden und vom Schritt gemäß Figur 1 zum Schritt gemäß Figur 2a werden 1 bis 3 Monolagen von H₂O entfernt beziehungsweise im Reservoir 5 aufgenommen.

In dem in Figur 2a gezeigten Schritt sind die Wasserstoffbrückenbindungen nunmehr unmittelbar zwischen Siloxan-Gruppen gebildet, wodurch eine stärkere Bondkraft entsteht. Hierdurch werden die Kontaktflächen 3, 4 stärker aneinander gezogen und der Abstand zwischen den Kontaktflächen 3, 4 wird reduziert. Es liegen dementsprechend nur noch 1 bis 2 Einzelschichten von OH-Gruppen zwischen den Kontaktflächen 1, 2 vor.

In dem in Figur 2b gezeigten Schritt werden nunmehr wiederum unter Abscheidung von H₂O-Molekülen gemäß nachfolgend eingeblendeter Reaktion kovalente Verbindungen in Form von Silanol-Gruppen zwischen den Kontaktflächen 3, 4 gebildet, die zu einer deutlich stärkeren Bondkraft führen und weniger Platz benötigen, so dass der Abstand zwischen den Kontaktflächen 3, 4 weiter verringert wird, bis schließlich der in Figur 3 gezeigte minimale Abstand auf Grund des direkten Aufeinandertreffens der Kontaktflächen 3, 4 erreicht wird:

Si-OH + HO-Si ←→ Si-O-Si+H₂O

Bis zur Stufe 3 ist es, insbesondere wegen der Schaffung des Reservoirs 5, nicht notwendig, die Temperatur übermäßig zu erhöhen, eher sogar bei Raumtemperatur ablaufen zu lassen. Auf diese Weise ist ein besonders schonender Ablauf der Verfahrensschritte gemäß Figur 1 bis Figur 3 möglich.

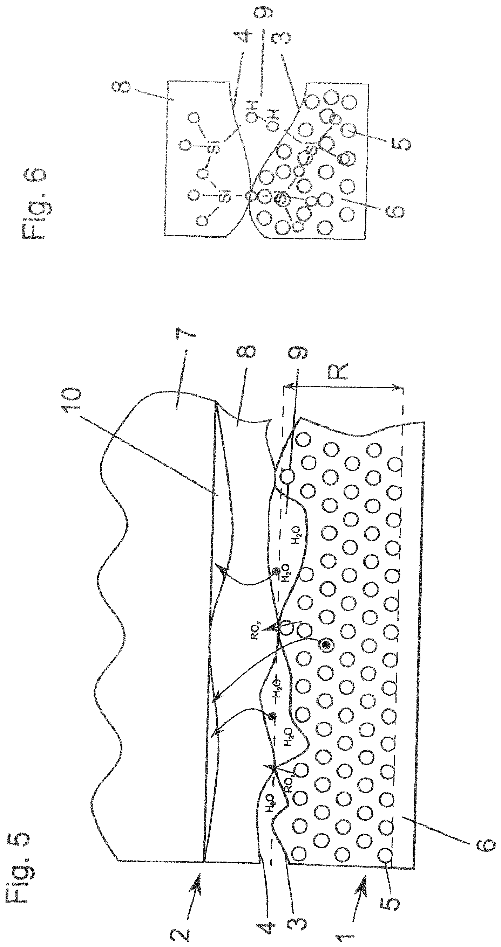

In dem in Figur 4 gezeigten Verfahrensschritt wird die Temperatur mit Vorzug auf maximal 500° Celsius, mit größerem Vorzug auf maximal 300°C mit noch größerem Vorzug auf maximal 200°C, mit größtem Vorzug auf maximal 100°C, mit allergrößtem Vorzug nicht über Raumtemperatur erhöht, um einen irreversiblen beziehungsweise permanenten Bond zwischen der ersten und der zweiten Kontaktfläche zu schaffen. Diese, im Gegensatz zum Stand der Technik, relativ niedrigen Temperaturen sind nur möglich, weil das Reservoir 5 das erste Edukt für die in Figur 5 und 6 gezeigte Reaktion umfasst:

Si + 2H₂O → SiO₂ + 2H₂

Bei den obengenanten, leicht erhöhten Temperaturen diffundieren H₂O-Moleküle als erstes Edukt von dem Reservoir 5 zur Reaktionsschicht 7. Diese Diffusion kann entweder über einen Direktkontakt der als Oxidschichten ausgebildeten Oberflächenschicht 6 und Aufwuchsschicht 8, oder über eine/aus einer zwischen den Oxidschichten vorliegende Lücke 9, erfolgen. Dort wird Siliziumdioxid, also eine chemische Verbindung mit einem größeren molaren Volumen als reines Silizium, als Reaktionsprodukt 10 der obigen Reaktion aus der Reaktionsschicht 7 gebildet. Das Siliziumdioxid wächst an der Grenzfläche der Reaktionsschicht 7 mit der Aufwuchsschicht 8 und verformt dadurch die Schicht der als natives Oxid ausgebildeten Aufwuchsschicht 8, in Richtung der Lücken 9 aus. Auch hierbei werden H₂O-Moleküle aus dem Reservoir benötigt.

Durch die Existenz der Lücken, die im Nanometerbereich liegen, besteht die Möglichkeit des Ausbeulens der nativen Oxidschicht 8, wodurch Spannungen an den Kontaktflächen 3, 4 reduziert werden können. Hierdurch wird der Abstand zwischen den Kontaktflächen 3, 4 reduziert, wodurch sich die wirksame Kontaktfläche und damit die Bondstärke weiter erhöht. Die so zustande gekommene, sich über den gesamten Wafer ausbildende, alle Poren verschließende, Schweißverbindung trägt, im Gegensatz zu den partiell nicht verschweißten Produkten im Stand der Technik, fundamental zur Erhöhung der Bondkraft bei. Der Bindungstyp zwischen beiden miteinander verschweißten amorphen Siliziumoxidoberflächen ist eine Mischform aus kovalentem und ionischem Anteil sein.

Besonders schnell beziehungsweise bei möglichst niedrigen Temperaturen erfolgt die oben genannte Reaktion des ersten Edukts (H₂O) mit dem zweiten Edukt (Si) in der Reaktionsschicht 7, soweit ein mittlerer Abstand B zwischen der ersten Kontaktfläche 3 und der Reaktionsschicht 7 möglichst gering ist.

Entscheidend ist daher die Vorbehandlung des ersten Substrats 1 sowie die Auswahl des zweiten Substrats 2, das aus einer Reaktionsschicht 7 aus Silizium und einer möglichst dünnen nativen Oxidschicht als Aufwuchsschicht 8 besteht. Eine möglichst dünne native Oxidschicht ist aus zwei Gründen erfindungsgemäß vorgesehen. Die Aufwuchsschicht 8 ist sehr dünn, damit sie sich durch das neu gebildete Reaktionsprodukt 10 an der Reaktionsschicht 7 zur als Oxidschicht ausgebildeten Oberflächenschicht 6 des gegenüberliegenden Substrats 1 hin ausbeulen kann, und zwar vorwiegend in Bereichen der Nano-Lücken 9. Des Weiteren sind möglichst kurze Diffusionswege erwünscht, um den erwünschten Effekt möglichst rasch und bei möglichst niedriger Temperatur zu erzielen. Das erste Substrat 1 besteht ebenfalls aus einer Siliziumschicht und einer darauf erzeugten Oxidschicht als Oberflächenschicht 6, in der zumindest teilweise oder vollständig ein Reservoir 5 ausgebildet wird.

In dem Reservoir 5 werden erfindungsgemäß mindestens entsprechend der zum Schließen der Nano-Lücken 9 erforderliche Menge an erstem Edukt aufgefüllt, damit ein optimales Aufwachsen der Aufwuchsschicht 8 zum Schließen der Nano-Lücken 9 in möglichst kurzer Zeit und/oder bei möglichst geringer Temperatur erfolgen kann.

### Bezugszeichenliste

- 1: erstes Substrat
- 2: zweites Substrat
- 3: erste Kontaktfläche
- 4: zweite Kontaktfläche
- 5: Reservoir
- 6: Oberflächenschicht
- 7: Reaktionsschicht
- 8: Aufwuchsschicht
- 9: Nano-Lücken
- 10: Reaktionsprodukt
- 11: Erstes Profil
- 12: Zweites Profil
- 13: Summenkurve
- A: mittlere Dicke
- B: mittlerer Abstand
- R: mittlere Dicke

## Patentansprüche

1. Verfahren zum Bonden einer ersten Kontaktfläche (3) eines ersten Substrats (1) mit einer zweiten Kontaktfläche (4) eines zweiten Substrats (2) mit folgenden Schritten, insbesondere folgendem Ablauf:
- Ausbildung eines Reservoirs (5) in einer Oberflächenschicht (6) an der ersten Kontaktfläche (3) durch Beaufschlagung der ersten Kontaktfläche (3) mit N₂-Gas und/oder O₂-Gas und/oder Ar-Gas und/oder Formiergas, insbesondere bestehend aus 95% Ar und 5% H₂,
- zumindest teilweises Auffüllen des Reservoirs (5) mit einem ersten Edukt oder einer ersten Gruppe von Edukten,
- Kontaktieren der ersten Kontaktfläche (3) mit der zweiten Kontaktfläche (4) zur Ausbildung einer Pre-Bond-Verbindung,
- Ausbildung eines permanenten Bonds zwischen der ersten und zweiten Kontaktfläche (3, 4), zumindest teilweise verstärkt durch Reaktion des ersten Edukts mit einem in einer Reaktionsschicht (7) des zweiten Substrats (2) enthaltenen zweiten Edukt.

2. Verfahren nach Anspruch 1, bei dem Ausbildung und/oder Verstärkung des permanenten Bonds durch Diffusion des ersten Edukts in die Reaktionsschicht (7) erfolgt.

3. Verfahren nach einem der vorhergehenden Ansprüche, bei dem die Ausbildung des permanenten Bonds bei einer Temperatur zwischen Raumtemperatur und 200° Celsius, insbesondere während maximal 12 Tagen, vorzugsweise maximal 1 Tag, noch bevorzugter maximal 1 Stunde, am besten maximal 15 min. erfolgt.

4. Verfahren nach einem der vorhergehenden Ansprüche, bei dem der irreversible Bond eine Bondstärke von größer 1,5 J/m², insbesondere größer 2 J/m², vorzugsweise größer 2,5 J/m² aufweist.

5. Verfahren nach einem der vorhergehenden Ansprüche, bei dem bei der Reaktion ein Reaktionsprodukt (10) mit einem größeren molaren Volumen als das molare Volumen des zweiten Edukts in der Reaktionsschicht (7) gebildet wird.

6. Verfahren nach einem der vorhergehenden Ansprüche, bei dem die Ausbildung des Reservoirs (5) durch Plasmaaktivierung erfolgt, wodurch sich reduzierte Spezies der im Plasmaprozess vorhandenen Ionen im Reservoir befinden, insbesondere O₂-, N₂-, H₂-, oder Ar-Ionen.

7. Verfahren nach einem der vorhergehenden Ansprüche, bei dem die Oberflächenschicht (6) überwiegend, insbesondere im wesentlichen vollständig, aus einem, insbesondere amorphen Material, insbesondere einem durch thermische Oxidation erzeugten Siliziumdioxid, und die Reaktionsschicht (7) aus einem oxidierbaren Material, insbesondere überwiegend, vorzugsweise im wesentlichen vollständig, aus Si, Ge, InP, GaP oder GaN, bestehen.

8. Verfahren nach einem der vorhergehenden Ansprüche, bei dem zwischen der zweiten Kontaktfläche (4) und der Reaktionsschicht (7) eine Aufwuchsschicht (8), insbesondere überwiegend aus nativem Siliziumdioxid, vorgesehen ist.

9. Verfahren nach Anspruch 8, bei dem die Aufwuchsschicht (8) vor der Ausbildung eines permanenten Bonds eine mittlere Dicke A zwischen 1 Angström und 10 nm aufweist.

10. Verfahren nach einem der vorhergehenden Ansprüche, bei dem die Ausbildung eines Reservoirs im Vakuum durchgeführt wird.

11. Verfahren nach einem der vorhergehenden Ansprüche, bei dem das Reservoir (5) in einer mittleren Dicke (R) zwischen 0.1 nm und 25 nm, insbesondere zwischen 0.1 nm und 20 nm, ausgebildet wird.

12. Verfahren nach einem der vorhergehenden Ansprüche, bei dem der mittlere Abstand (B) zwischen dem Reservoir (5) und der Reaktionsschicht (7) unmittelbar vor der Ausbildung des permanenten Bonds zwischen 0,1 nm und 15 nm, insbesondere zwischen 0,5 nm und 5 nm, vorzugsweise zwischen 0,5 nm und 3 nm beträgt.
